# FASCICULE DE BREVET EUROPEEN

(11) **EP 2 471 111 B1**
(45) Date de publication et mention de la délivrance du brevet: **02.10.2013**
(21) Numéro de dépôt: 10762742.4
(22) Date de dépôt: 23.08.2010
(51) Int. Cl.: H01L 31/18, C30B 33/12, C30B 29/06

(54) **PROCEDE DE NETTOYAGE DE LA SURFACE D'UN SUBSTRAT DE SILICIUM**
VERFAHREN ZUR REINIGUNG DER OBERFLÄCHE EINES SILIZIUMSUBSTRATS
PROCESS FOR CLEANING THE SURFACE OF A SILICON SUBSTRATE

(30) Priorité: 24.08.2009 FR 0955766
(43) Date de publication de la demande: 04.07.2012
(73) Titulaire: Ecole Polytechnique, 91120 Palaiseau Cédex (FR); Centre National de la Recherche Scientifique, 75794 Paris Cedex 16 (FR)
(72) Inventeur: ROCA I CABARROCAS, Pere, 91140 Villebon Sur Yvette (FR); MORENO, Mario, 91120 Palaiseau (FR)
(74) Mandataire: Coralis Harle
(86) Numéro de dépôt international: PCT/FR2010/051755
(87) Numéro de publication internationale: WO 2011/023893

(56) Documents cités:
- WO-A-2009/015213
- WO-A-2009/092453
- FR-A- 2 793 264
- BRANZ ET AL: "Recent advances in hot-wire CVD R&D at NREL: From 18% silicon heterojunction cells to silicon epitaxy at glass-compatible temperatures", THIN SOLID FILMS, ELSEVIER-SEQUOIA S.A. LAUSANNE, CH, vol. 516, no. 5, 15 janvier 2008 (2008-01-15), pages 743-746, XP022492169, ISSN: 0040-6090
- SEITZ H ET AL: "Influence of atomic hydrogen on the growth kinetics of a-Si:H films and on the properties of silicon substrates", THIN SOLID FILMS, ELSEVIER-SEQUOIA S.A. LAUSANNE, CH, vol. 395, no. 1-2, 3 septembre 2001 (2001-09-03), pages 116-120, XP004307680, ISSN: 0040-6090
- SCHMIDT M ET AL: "Physical aspects of a-Si:H/c-Si hetero-junction solar cells", THIN SOLID FILMS, ELSEVIER-SEQUOIA S.A. LAUSANNE, CH, vol. 515, no. 19, 16 juillet 2007 (2007-07-16), pages 7475-7480, XP022820256, ISSN: 0040-6090 [extrait le 2007-08-07]

## Description

L'invention concerne un procédé de nettoyage de la surface d'un substrat de silicium destiné à la fabrication d'une cellule solaire à hétérojonction.

Les cellules solaires de silicium cristallin sont largement utilisées l'industrie du photovoltaïque pour leur rendement élevé.

Les cellules solaires à hétérojonction permettent d'obtenir des rendements élevés (> 22 %), même pour des cellules solaires obtenues à partir d'une galette de silicium très mince (∼100 µm).

Le document WO-A-2009/015213 enseigne un procédé de nettoyage de la surface d'un substrat de silicium comprenant une étape d'exposition de la surface à un plasma RF d'argon ou d'hydrogène.

Il est aussi connu qu'après une étape de texturation de leur surface, les substrats de silicium subissent une étape de gravure par voie chimique humide pour nettoyer la surface du substrat de silicium, c'est-à-dire pour retirer la couche d'oxyde de silicium (SiO₂), naturellement formée sur la surface du substrat. Ce procédé par voie chimique humide est connu du document « Karen Reinhardt, Werner Kern, Handbook of Semiconductor Wafer Cleaning Technology, 2nd edition (2007) ».

Ce procédé de nettoyage par voie chimique humide nécessite l'utilisation de solutions comme celles à base d'acide fluorhydrique (HF), par exemple, et d'eau déionisée.

Cependant, la quantité relativement élevée d'eau déionisée et de produits chimiques utilisés dans ces processus par voie humide représente une source de pollution importante et entraîne des coûts de fabrication importants.

Ainsi, l'invention a pour objet de fournir un procédé de nettoyage de la surface d'un substrat de silicium par voie sèche permettant d'éviter l'utilisation de produits chimiques liquides polluants, et de réduire les coûts de fabrication.

A cet effet, l'invention concerne un procédé de nettoyage de la surface d'un substrat de silicium, ladite surface étant initialement recouverte d'une couche d'oxyde de silicium.

Selon l'invention, le procédé comprend les étapes suivantes :
a) exposition de ladite surface à un plasma radiofréquence généré à partir d'un gaz fluoré dans une chambre de réaction, produisant le décapage de la couche d'oxyde de silicium, et générant l'adsorption d'éléments fluorés sur la surface du substrat de silicium, ladite exposition étant réalisée pendant une durée comprise entre 60 s et 900 s, la densité de puissance générée avec le plasma étant comprise entre 10 mW/cm² et 350 mW/cm², la pression du gaz fluoré dans la chambre de réaction étant comprise entre 10 mTorr et 200 mTorr, et la température du substrat de silicium étant inférieure ou égale à 300°C, et
b) exposition de ladite surface comprenant les éléments fluorés à un plasma radiofréquence d'hydrogène dans la chambre de réaction, pour élimer lesdits éléments fluorés de la surface du substrat, ladite exposition étant réalisée pendant une durée comprise entre 5 s et 120 s, la densité de puissance générée avec le plasma étant comprise entre 10 mW/cm² et 350 mW/cm², la pression d'hydrogène dans la chambre de réaction étant comprise entre 10 mTorr et 1 Torr, et la température du substrat de silicium étant inférieure ou égale à 300 °C.

Dans différents modes de réalisation possibles, la présente invention concerne également les caractéristiques suivantes qui pourront être considérées isolément ou selon toutes leurs combinaisons techniquement possibles et apportent chacune des avantages spécifiques :
- lors des étapes a) et b), la puissance du plasma radiofréquence est de 10 W,
- lors de l'étape a), le gaz fluoré utilisé est un gaz de SiF₄,
- lors de l'étape a), la pression de SiF₄ dans la chambre de réaction est de 30 mTorr,
- l'étape a) est réalisée pendant une durée de 380 s,
- lors des étapes a) et b), la température du substrat de silicium est de 150°C,
- la durée de l'étape b) est de 30 s, la pression d'hydrogène dans la chambre de réaction étant de 500 mTorr,
- la chambre de réaction est une chambre de réacteur de dépôt chimique en phase vapeur assisté par plasma.

Ainsi, l'invention fournit un procédé de nettoyage de la surface d'un substrat de silicium par voie sèche permettant d'éviter l'utilisation de produits chimiques liquides polluants, et de réduire les coûts de fabrication.

De plus, les propriétés électro-optiques des substrats obtenus avec le procédé de l'invention sont proches de celles obtenues avec les procédés par voie humide de l'art antérieur.

Ce procédé permet également de réaliser les principales étapes de fabrication des cellules solaires dans un même ensemble ou cluster comprenant plusieurs chambres de réaction (pour la texturation, la gravure, le dépôt). Les différentes chambres sous vide communicant entre elles, cela permet d'éviter la contamination du substrat par des polluants extérieurs.

L'invention sera décrite plus en détail en référence aux dessins annexés dans lesquels :
- la figure 1 représente des valeurs de E₂ pour divers rapports SiF₄/H₂ utilisés lors de l'étape a) ;
- la figure 2 représente l'amplitude de E₂ en fonction de la durée d'exposition au plasma SiF₄ lors de l'étape a) ;

Selon un mode de réalisation de l'invention, le procédé de nettoyage de la surface du substrat de silicium, initialement recouverte d'une couche d'oxyde de silicium natif, comprend une étape a) d'exposition de la surface à un plasma radiofréquence généré à partir d'un gaz fluoré dans une chambre de réaction, produisant le décapage de la couche d'oxyde de silicium par gravure en phase gazeuse (voie sèche).

Un gaz fluoré est injecté dans la chambre de réaction d'un réacteur de dépôt chimique en phase vapeur assisté par plasma (PECVD). Le plasma excité par une tension radiofréquence (RF) comprend des éléments à base de fluor (molécules, atomes, ions).

Cette étape a) est réalisée pendant une durée comprise entre 60 s et 900 s. La puissance du plasma est comprise entre 1 W et 30 W, correspondant à une densité de puissance comprise entre 10 mW/cm² et 350 mW/cm². La pression du gaz fluoré est comprise entre 10 mTorr et 200 mTorr.

Le gaz fluoré (ou à base de fluor) est préférentiellement un gaz de SiF₄. D'autres gaz fluorés peuvent être utilisés, comme le SF₆, par exemple.

Cette étape a) entraîne la fixation ou l'adsorption d'éléments fluorés sur la surface du substrat de silicium, provocant des défauts de surface, en particulier des liaisons Si brisées.

Le procédé de nettoyage de la surface du substrat de silicium comprend également une étape b) d'exposition de la surface du substrat de silicium comprenant des éléments fluorés à un plasma radiofréquence d'hydrogène, pour retirer les éléments fluorés de la surface du substrat de silicium.

Le plasma obtenu lors des étapes a) et b) est un plasma basse température (température inférieure ou égale à 300 °C).

Cette étape b) est réalisée pendant une durée comprise entre 5 s et 120 s, et avec une puissance de plasma comprise entre 1 W et 30 W (densité de puissance comprise entre 10 mW/cm² et 350 mW/cm²).

La pression d'hydrogène est comprise entre 10 mTorr et 1 Torr.

Les étapes a) et b) sont réalisées dans un réacteur de dépôt chimique en phase vapeur assisté par plasma (PECVD) classique, fonctionnant à une fréquence de 13,56 MHz.

Lors des étapes a) et b), la température du substrat de silicium est inférieure ou égale à 300 °C.

Le procédé de nettoyage de l'invention peut être utilisé pour tout type de substrats de silicium, monocristallin (c-Si) ou polycristallin par exemple, dopé p ou n, et d'orientation <100>, <110> ou <111>, avec une résistivité comprise entre 0,5 Ω.cm et 30 Ω.cm, par exemple.

La partie imaginaire de la fonction pseudo-diélectrique (lm [ε]) d'un substrat de silicium peut être mesurée par ellipsomètrie UV-visible, dans la gamme d'énergie comprise entre 1,5 et 4,5 eV.

E₂ représente la valeur de lm [ε] à 4,2 eV (crête de lm [ε]). L'amplitude de E₂ est liée à la qualité de la surface du substrat de silicium et à la présence de SiO₂ sur la surface de substrat.

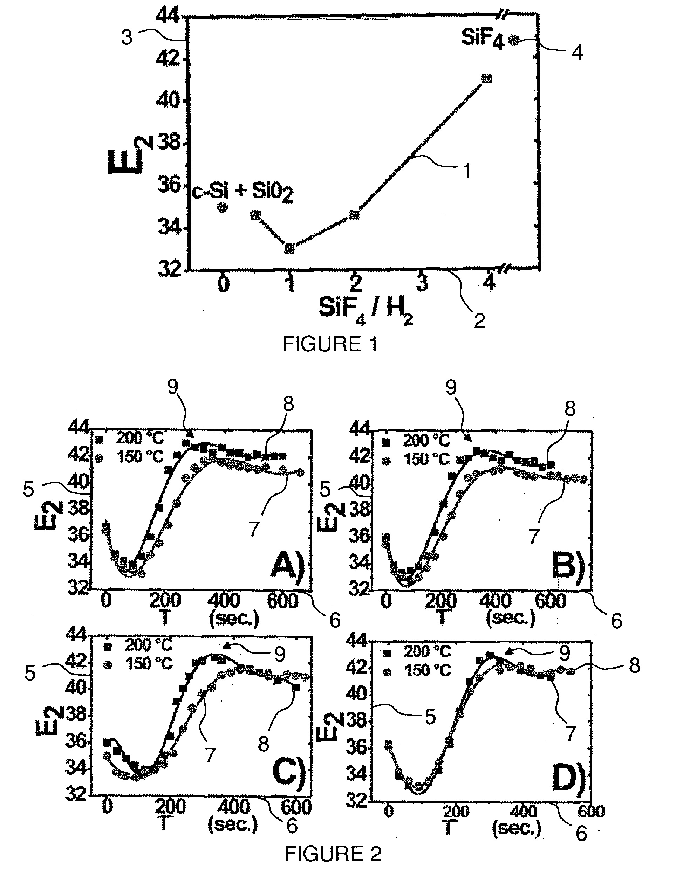

La figure 1 représente des valeurs d'E₂ 1, après 5 minutes d'exposition au plasma RF, pour divers rapports SiF₄/H₂.

Les abscisses 2 représentent les rapports SiF₄/H₂, et les ordonnées 3 représentent l'amplitude de E₂.

L'amplitude de E₂ augmente avec le rapport SiF₄/H₂, jusqu'à un maximum 4 dans le cas d'un plasma SiF₄ pur. Ces résultats montrent que durant l'étape a), l'utilisation d'un plasma de SiF₄ pur est plus efficace pour graver le SiO₂ natif qu'un plasma basé sur un mélange de SiF₄/H₂.

La figure 2 représente l'amplitude de E₂ 5 en fonction de la durée d'exposition au plasma SiF₄ 6 pour 4 substrats différents, et pour deux températures de substrat 150°C (courbe 7) et 200°C (courbe 8).

Le graphique A correspond à un substrat CZ <100> dopé p ayant une conductivité comprise entre 14 et 22 Ω cm.

Le graphique B correspond à un substrat FZ <100> dopé p ayant une conductivité comprise entre 5 et 10 Ω cm.

Le graphique C correspond à un substrat FZ <100> dopé n ayant une conductivité comprise entre 1 et 5 Ω cm.

Le graphique D correspond à un substrat FZ <111> dopé n ayant une conductivité comprise entre 1 et 5 Ω cm.

La puissance du plasma est de 10 W, la pression dans la chambre de réaction est de 30 mTorr, le flux de SiF₄ est de 100 sccm.

De façon générale pour tous les substrats, au début de l'exposition au plasma, l'amplitude d'E₂ diminue. A ce stade, le plasma crée de la rugosité pendant la gravure du SiO₂ par voie sèche à partir de la surface du substrat de silicium.

Après une durée d'exposition au plasma plus longue, l'amplitude de E₂ augmente jusqu'à un maximum 9, qui est dû au décapage complet du SiO₂.

Pour des durées d'exposition au plasma encore plus longues, l'amplitude E₂ diminue en raison de la rugosité de la surface du substrat induite par la gravure du silicium par le plasma de SiF₄.

Le temps nécessaire pour que l'amplitude de E₂ atteigne un maximum dépend de la température de substrat. A 200 °C, le temps optimum de gravure est d'environ 300 s pour les quatre types de substrats, alors qu'à 150 °C, le temps optimum de gravure atteint environ 380 s.

Quand le SiO₂ est gravé au plasma avec une température de substrat de 200°C, l'amplitude de E₂ est plus grande que celle correspondant à une gravure effectuée avec une température de substrat de 150°C, suggérant une meilleure qualité du substrat.

Cependant, des valeurs élevées de E₂ pour un substrat nettoyé n'impliquent pas nécessairement que les propriétés électroniques de la surface conviennent à une cellule solaire.

Afin d'optimiser le procédé de nettoyage, il est nécessaire de caractériser le substrat de silicium après une étape de passivation de la surface du substrat au moyen d'un plasma de SiH₄. Cette étape de passivation est obtenue en recouvrant la surface du substrat d'une couche de silicium a-Si:H.

Divers traitements ont été appliqués sur le substrat de silicium cristallin entre l'étape a) d'exposition au plasma de SiF₄ et le dépôt de a-Si :H.

Ces études sont résumées dans le tableau I. On a utilisé un substrat de silicium FZ <100> de type n ayant une conductivité comprise entre 1 et 5 Ω.cm, et une épaisseur de 280 µm. Une couche de 40 nanomètres de a-Si :H a ensuite été déposée sur les deux faces du substrat par plasma de SiH₄ pur après élimination du SiO₂ natif, sans casser le vide dans la chambre de réaction.

Les études du tableau I ci-dessous permettent de définir les conditions de traitement optimales pour un nettoyage efficace des substrats de silicium.

| Conditions pour le procédé de nettoyage | | | | | | Résultats après passivation | | | |
|---|---|---|---|---|---|---|---|---|---|
| Ref. de l'expérience | T_{sub} (°C) | Gravure du SiO₂ au plasma SiF₄ (étape a)) | | Traitement au plasma avant le dépôt du a-Si.H | | Durée de vie τ_{eff} avant recuit (ms) | Durée de vie τ_{eff} après recuit à 200 °C (ms) | Voc (V) | Vitesse de recombin aison à la surface (cm s⁻¹) |
| | | Puissance (W) | Temps (s) | Gaz | Temps (s) | | | | |
| M0801105 Référence (HF) | 150 | No | No | No | | 1.71 | 1.75 | 0.722 | 8 |
| M090205 | 200 | 10 | 300 | No | | 0.017 | 0.014 | 0.551 | 1000 |
| M090205-2 | 150 | 10 | 380 | No | | 0.090 | 0.219 | 0.634 | 63 |
| M090206-1 | 150 | 10 | 380 | Epitaxie | 360 | 0.020 | 0.020 | 0.562 | 682 |
| M090209-1 | 150 | 10 | 380 | Ar | 60 | 0.018 | 0.031 | 0.624 | 444 |
| M0902010-2 | 150 | 10 | 380 | Ar | 30 | 0.118 | 0.163 | 0.648 | 85 |
| M0902010-1 | 150 | 10 | 380 | H2 | 60 | 0.899 | 0.961 | 0.694 | 14.5 |
| M090316-2 | 150 | 10 | 380 | H2 | 30 | 1.13 | 1.23 | 0.701 | 12.4 |
| M090212-1 | 150 | 5 | 380 | H2 | 30 | 1.51 | 1.55 | 0.716 | 9 |

Il a été utilisé comme référence un substrat c-Si nettoyé avec une solution standard d'acide fluorhydrique diluée à 5% avec de l'eau déionisée. Ce substrat a ensuite été passivé sur ces deux faces. Une couche de 40 mm de a-Si :H a été déposée sur ces deux faces. On obtient une durée de vie effective (τ_{eff}) des porteurs de charges de 1,75 ms.

La durée de vie effective (τ_{eff}) est obtenue avec un appareil mesurant le transitoire de photoconductance (Sinton WTC-120). L'échantillon est illuminé avec une lampe flash afin de produire des porteurs de charges en excès dans le substrat c-Si, créant un changement de la conductivité du substrat.

La dépendance du τ_{eff} en fonction de la densité de porteurs en excès (Δn=Δp) est alors mesurée. On en déduit le Voc implicite à une illumination de 1 soleil.

L'effet de la température du substrat a été analysé en premier. Bien que les résultats concernant le procédé de nettoyage au plasma SiF₄ suggèrent une meilleure qualité de la surface à 200 °C (voir la fig. 2), on a obtenu une durée de vie très basse (τ_{eff} = 17 µs) pour l'échantillon traité à 200°C, et recouvert d'une couche de a-Si:H (voir le Tableau I).

Alors que l'échantillon traité à 150°C conduit à une durée de vie de 90 µs après un dépôt de a-Si:H, et à une durée de vie de 0,219 ms après un recuit à 200°C pendant une demi-heure à l'air ambiant.

Dans le cas de l'échantillon traité à 200°C, le recuit a eu comme conséquence une petite dégradation de la durée de vie des porteurs de charges.

On en déduit que pour l'étape a), une température inférieure à 200°C est préférable. Une température de 150°C est idéale.

Afin d'améliorer la qualité de la couche de passivation sur la surface du substrat de silicium, divers traitements au plasma, après l'étape a) de gravure du SiO₂ au plasma SiF₄, ont été testés, comme montrés dans le Tableau I.

Des couches épitaxiales de silicium de 40 nanomètres ont été déposées sur le substrat de c-Si avant le dépôt de la couche de a-Si:H, ce qui n'a produit aucune amélioration du τ_{eff}. En fait, il a été ramené à 20 µs, ce qui n'est pas étonnant puisque dans ce cas il n'y a pas d'hétérojonction (pas de couche a-Si:H).

Un traitement du substrat de silicium c-Si au plasma d'Argon, entre l'étape a) d'exposition au plasma de SiF₄ et le dépôt de a-Si:H, a eu comme conséquence une dégradation des propriétés électriques du substrat.

La dégradation des propriétés électriques du substrat est plus importante pour un traitement au plasma d'argon pendant 60 s que pour un traitement de 30 s. Dans les deux cas le recuit n'a produit aucune amélioration substantielle pour la durée de vie des porteurs de charges (τ_{eff} ≈ 163 µs, après recuit pour l'échantillon traité pendant 30 s).

De façon surprenante, l'utilisation de l'étape b) d'exposition de la surface du substrat à un plasma d'H₂ a produit une amélioration exceptionnelle des caractéristiques électriques des échantillons passivés. Le τ_{eff} a augmenté jusqu'à 961 µs et jusqu'à 1,23 ms (après recuit) pour des temps de traitement au plasma d'hydrogène de 60 s et de 30 s, respectivement.

Pour réduire les dommages à la surface du c-Si avant le dépôt de la couche de a-Si:H, lors de l'étape a), la puissance RF du plasma de SiF₄ a été abaissée à 5 W. Cette étape a) a été suivie de l'étape b) dans laquelle un plasma d'H₂ a été appliqué pendant 30 s. Comme prévu, le τ_{eff} a grimpé jusqu'à 1,5 ms (1,55 ms après recuit), ce qui est comparable à la valeur de τ_{eff} obtenue pour l'échantillon de référence.

Le plasma de SiF₄ utilisé lors de l'étape a) pour éliminer l'oxyde natif de SiO₂, produit les liaisons pendantes entre les atomes de silicium à la surface du substrat à cause du bombardement par les ions fluorés.

Une exposition courte au plasma d'H₂ permet de passiver la surface du substrat comprenant ces défauts, d'une manière semblable à celle du procédé par voie humide utilisant l'acide fluorhydrique.

Des mesures de la durée de vie des porteurs de charges ont permis d'obtenir la tension de circuit ouvert (Voc) implicite et la limite supérieure de la vitesse de recombinaison de surface (S_{eff}).

Les valeurs sont proches de celles obtenues avec le procédé par voie humide de l'art antérieur utilisant l'acide fluorhydrique.

De façon préférée, lors de l'étape a) d'exposition de la surface du substrat à un plasma radiofréquence basse température, il est utilisé un gaz fluoré de SiF₄ pur, sans ajout d'hydrogène, ni d'autre gaz. Seul le gaz SiF₄ est injecté dans la chambre PECVD durant l'étape a). La pression de SiF₄ est de 30 mTorr. La durée de l'étape a) est de 380 s.

L'étape b) d'exposition de la surface fluorée à un plasma radiofréquence d'hydrogène basse température est appliquée pendant 30 s.

Lors des étapes a) et b), la puissance du plasma radiofréquence est comprise entre 5 W et 10 W, de préférence égale à 10 W, et la température du substrat de silicium est de 150 °C.

Selon un mode de réalisation possible, le procédé de nettoyage comprend, après les étapes a) et b), une étape c) de dépôt de silicium amorphe (a-Si :H) intrinsèque ou dopé type p ou type n, ou d'autres matériaux amorphes (comme a-SiC:H, a-SiGe:H, ou SiNₓ par exemple), de différentes épaisseurs comprise entre 1 nm et 200 nm.

Le procédé de nettoyage comprend également, après l'étape c), une étape d) de recuit du substrat de silicium à une température comprise entre 150°C et 300 °C, pendant une durée comprise entre 10 min et 120 min, de préférence de 30 min. Cette étape de recuit est facultative.

On obtient une durée de vie des porteurs de charges de 1,55 ms, une tension de circuit ouvert de 0,716 V, et une vitesse de recombinaison de surface de 9 cm.s⁻¹.

Selon un mode de réalisation possible, pendant les étapes a) et/ou b) et/ou c), la puissance du plasma radiofréquence est appliquée directement ou augmentée progressivement.

Le procédé de l'invention permet d'être mis en oeuvre dans une chambre de dépôt chimique en phase vapeur assisté par plasma (PECVD) unique. Les étapes a), b) et c) sont réalisées dans cette même chambre (PECVD), permettant d'éviter de casser le vide, de contaminer le substrat par des polluants extérieurs, d'augmenter la rapidité du procédé de nettoyage et de réduire les coûts de fabrication.

Le procédé de l'invention peut être appliqué sur une ou les deux faces opposées du substrat de silicium.

## Revendications

1. Procédé de nettoyage de la surface d'un substrat de silicium, ladite surface étant recouverte d'une couche d'oxyde de silicium,
**caractérisé en ce qu'**il comprend les étapes suivantes :
a) exposition de ladite surface à un plasma radiofréquence généré à partir d'un gaz fluoré dans une chambre de réaction, produisant le décapage de la couche d'oxyde de silicium, et générant l'adsorption d'éléments fluorés sur la surface du substrat de silicium, ladite exposition étant réalisée pendant une durée comprise entre 60 s et 900 s, la densité de puissance générée avec le plasma étant comprise entre 10 mW/cm² et 350 mW/cm², la pression du gaz fluoré dans la chambre de réaction étant comprise entre 10 mTorr et 200 mTorr, et la température du substrat de silicium étant inférieure ou égale à 300 °C, et
b) exposition de ladite surface comprenant les éléments fluorés à un plasma radiofréquence d'hydrogène dans ladite chambre de réaction, pour élimer lesdits éléments fluorés de la surface du substrat, ladite exposition étant réalisée pendant une durée comprise entre 5 s et 120 s, la densité de puissance générée avec le plasma étant comprise entre 10 mW/cm² et 350 mW/cm², la pression d'hydrogène dans la chambre de réaction étant comprise entre 10 mTorr et 1 Torr, et la température du substrat de silicium étant inférieure ou égale à 300 °C.

2. Procédé de nettoyage de la surface d'un substrat de silicium selon la revendication 1, **caractérisé en ce que**, lors des étapes a) et b), la puissance du plasma radiofréquence est de 10 W.

3. Procédé de nettoyage de la surface d'un substrat de silicium selon l'une quelconque des revendications 1 ou 2, **caractérisé en ce que**, lors de l'étape a), le gaz fluoré utilisé est un gaz de SiF₄.

4. Procédé de nettoyage de la surface d'un substrat de silicium selon l'une quelconque des revendications 1 à 3, **caractérisé en ce que**, lors de l'étape a), la pression de SiF₄ dans la chambre de réaction est de 30 mTorr.

5. Procédé de nettoyage de la surface d'un substrat de silicium selon l'une quelconque des revendications 1 à 4, **caractérisé en ce que** l'étape a) est réalisée pendant une durée de 380 s.

6. Procédé de nettoyage de la surface d'un substrat de silicium selon l'une quelconque des revendications 1 à 5, **caractérisé en ce que**, lors des étapes a) et b), la température du substrat de silicium est de 150 °C.

7. Procédé de nettoyage de la surface d'un substrat de silicium selon l'une quelconque des revendications 1 à 6, **caractérisé en ce que** la durée de l'étape b) est de 30 s, la pression d'hydrogène dans la chambre de réaction étant de 500 mTorr.

8. Procédé de nettoyage de la surface d'un substrat de silicium selon l'une quelconque des revendications 1 à 7, **caractérisé en ce que** la chambre de réaction est une chambre de réacteur de dépôt chimique en phase vapeur assisté par plasma.

## Patentansprüche

1. Verfahren zum Reinigen der Oberfläche eines Siliciumsubstrats, wobei die Oberfläche mit einer Siliciumoxidschicht bedeckt ist,
**dadurch gekennzeichnet, dass** es die folgenden Schritte umfasst:
a) Einwirkenlassen eines Hochfrequenzplasmas, das in einer Reaktionskammer ausgehend von einem fluorhaltigen Gas erzeugt wird, auf die Oberfläche, wobei die Siliciumoxidschicht entfernt wird und es zu einer Adsorption fluorhaltiger Elemente an der Oberfläche des Siliciumsubstrats kommt, wobei die Einwirkungsdauer im Bereich von 60 s bis 900 s liegt, wobei das Plasma eine Leistungsdichte im Bereich von 10 mW/cm² bis 350 mW/cm² erzeugt, wobei der Druck des fluorhaltigen Gases in der Reaktionskammer im Bereich von 10 mTorr bis 200 mTorr liegt, und wobei die Temperatur des Siliciumsubstrats höchstens 300 °C beträgt, und
b) Einwirkenlassen, in der Reaktionskammer, eines Wasserstoff-Hochfrequenzplosmas auf die Oberfläche, welche die fluorhaltigen Elemente umfasst, um die fluorhaltigen Elemente von der Oberfläche des Substrats zu entfernen, wobei die Einwirkungsdauer im Bereich von 5 s bis 120 s liegt, wobei das Plasma eine Leistungsdichte im Bereich von 10 mW/cm² bis 350 mW/cm² erzeugt, wobei der Druck des Wasserstoffs in der Reaktionskammer im Bereich von 10 mTorr bis 1 Torr liegt, und wobei die Temperatur des Siliciumsubstrats höchstens 300 °C beträgt.

2. Verfahren zum Reinigen der Oberfläche eines Siliciumsubstrats nach Anspruch 1, **dadurch gekennzeichnet, dass** in den Schritten a) und b) die Leistung des Hochfrequenzplasmas 10 W beträgt.

3. Verfahren zum Reinigen der Oberfläche eines Siliciumsubstrats nach einem beliebigen der Ansprüche 1 oder 2, **dadurch gekennzeichnet, dass** es sich bei dem fluorhaltigen Gas, das in Schritt a) verwendet wird, um ein SiF₄-Gas handelt.

4. Verfahren zum Reinigen der Oberfläche eines Siliciumsubstrats nach einem beliebigen der Ansprüche 1 bis 3, **dadurch gekennzeichnet, dass** in Schritt a) der SiF₄-Druck in der Reaktionskammer 30 mTorr beträgt.

5. Verfahren zum Reinigen der Oberfläche eines Siliciumsubstrats nach einem beliebigen der Ansprüche 1 bis 4, **dadurch gekennzeichnet, dass** der Schritt a) während einer Dauer von 380 s durchgeführt wird.

6. Verfahren zum Reinigen der Oberfläche eines Siliciumsubstrats nach einem beliebigen der Ansprüche 1 bis 5, **dadurch gekennzeichnet, dass** in den Schritten a) und b) die Temperatur des Siliciumsubstrats 150 °C beträgt.

7. Verfahren zum Reinigen der Oberfläche eines Siliciumsubstrats nach einem beliebigen der Ansprüche 1 bis 6, **dadurch gekennzeichnet, dass** die Dauer des Schrittes b) 30 s beträgt, wobei der Wasserstoffdruck in der Reaktionskammer 500 mTorr beträgt.

8. Verfahren zum Reinigen der Oberfläche eines Siliciumsubstrats nach einem beliebigen der Ansprüche 1 bis 7, **dadurch gekennzeichnet, dass** es sich bei der Reaktionskammer um eine Kammer eines Reaktors für die plasmagestützte chemische Gasphasenabscheidung handelt.

## Claims

1. A method for cleaning the surface of a silicon substrate, said surface being covered with a layer of silicon oxide;
**characterized in that** the method comprises the following steps:
a) exposing said surface to a radiofrequency plasma generated from a fluorinated gas in a reaction chamber, resulting in stripping the layer of silicon oxide and causing fluorinated elements to be adsorbed onto the surface of the silicon substrate, said exposure being carried out for a period in the range 60 s to 900 s, the power density generated by the plasma being in the range 10 mW/cm² to 350 mW/cm², the pressure of the fluorinated gas in the reaction chamber being in the range 10 mTorr to 200 mTorr, and the temperature of the silicon substrate being 300°C or less; and
b) exposing said surface including the fluorinated elements to a hydrogen radiofrequency plasma in said reaction chamber, to eliminate said fluorinated elements from the surface of the substrate, said exposure being carried out for a period in the range 5 s to 120 s, the power density generated by the plasma being in the range 10 mW/cm² to 350 mW/cm², the pressure of hydrogen in the reaction chamber being in the range 10 mTorr to 1 Torr, and the temperature of the silicon substrate being 300°C or less.

2. A method for cleaning the surface of a silicon substrate according to claim 1, **characterized in that** during steps a) and b), the power of the radiofrequency plasma is 10 W.

3. A method for cleaning the surface of a silicon substrate according to claim 1 or claim 2, **characterized in that** during step a), the fluorinated gas used is a SiF₄ gas.

4. A method for cleaning the surface of a silicon substrate according to any one of claims 1 to 3, **characterized in that** during step a), the pressure of SiF₄ in the reaction chamber is 30 mTorr.

5. A method for cleaning the surface of a silicon substrate according to any one of claims 1 to 4, **characterized in that** step a) is carried out for a period of 380 s.

6. A method for cleaning the surface of a silicon substrate according to any one of claims 1 to 5, **characterized in that** during steps a) and b), the temperature of the silicon substrate is 150°C.

7. A method for cleaning the surface of a silicon substrate according to any one of claims 1 to 6, **characterized in that** the duration of step b) is 30 s, the hydrogen pressure in the reaction chamber being 500 mTorr.

8. A method for cleaning the surface of a silicon substrate according to any one of claims 1 to 7, **characterized in that** the reaction chamber is a chamber of a plasma enhanced chemical vapor deposition reactor.
